# EUROPEAN PATENT APPLICATION

(11) **EP 4 610 984 A1**
(43) Date of publication of application: **03.09.2025**
(21) Application number: 24305310.5
(22) Date of filing: 27.02.2024
(51) Int. Cl.: G11C 8/10, G11C 16/08, G11C 7/24, G11C 16/22

(54) **SECURE NON-VOLATILE MEMORY AND INTEGRATED CIRCUIT INCLUDING SAID NON-VOLATILE MEMORY**

(71) Applicant: THALES DIS FRANCE SAS, 92190 Meudon (FR)
(72) Inventor: NAURA, David, 13100 Aix en Provence (FR); GIOVINAZZI, Thierry, 83470 Saint Maximin La Sainte Baume (FR)
(74) Representative: Bricks, Amélie

(57) **Abstract**

The invention relates to non-volatile memory circuit (300) comprising at least one memory block (310) having a plurality of memory cells (MC_{1,1} to MC_{m,n}) located at intersection of bit lines (BL1 to BLn) and word lines (WL1 to WLm), and at least one line decoder (350, 380) receiving internal address bits for selecting one word line and one bit line. The non-volatile memory circuit (300) comprises at least one verify circuit (390) receiving the internal address bits and providing an alarm signal (ALARM) when the internal address bits correspond to a forbidden address.

## Description

### Technical Field

The invention relates to a secure non-volatile memory and secure integrated circuit including said non-volatile memory.

### Background Art

Secure integrated circuits are more and more used today. As an example, secure integrated circuit are used for any product needing a secure element like smart cards, smartphones, computers, or any communicating electronic device that should be securely connected. Security data, including password but also secure programs for making strong authentications are stored in a non-volatile memory that are preferably programmable and erasable, like Flash memories or EEPROMs (Electrically Erasable Programmable Read Only Memory) but ROM can also be used for storing security information. The non-volatile memory is embedded into a microcontroller or a System-on-Chip (SoC) component making a verification of password in such a way the password never goes out of the component. Nevertheless, there are some methods for retrieving the password from such component.

One method consists in a direct access to the component after removing protection resin from the component. Once the component is naked, the buses and the memory can be accessed by thin probe or by laser. In such a way to avoid a direct reading of the memory, the memory can be scrambled or encoded. Even if the memory is scrambled or encoded, a method, known as "fault attack", consists in altering the reading of the memory in such a way to cause some faults during the running of a secure program for locating where are the sensitive data or for deducing an algorithm.

A laser attack can be made of different manner at different location in the component. A laser attack can be made on the address bus between a processor unit and a memory for reading another data than the data requested by the processor. Such attacks are very difficult to detect but could be detected by a memory controller when an address corresponds to a forbidden address. In that case, the memory controller must compare the address received through the address bus with a table of forbidden addresses. Such a method is relatively time consuming and cannot be used if the attack is made between the memory controller and the memory.

There is a need to detect quickly such an attack at the memory level.

### Summary of the Invention

The invention provides a secure memory including a verify circuit for verifying if the address corresponds to an allowed address.

More particularly, the invention provides a non-volatile memory circuit comprising at least one memory block having a plurality of memory cells located at intersection of bit lines and word lines, and at least one line decoder receiving internal address bits for selecting one word line and one bit line. The non-volatile memory circuit comprises at least one verify circuit receiving the internal address bits and providing an alarm signal when the internal address bits correspond to a forbidden address.

In some cases, said memory can comprise a plurality of memory blocks, and wherein one memory block is activated by at least one internal address bit. Said memory can comprises at least one address buffer for memorizing an address and for providing the internal address bits, and wherein the verify circuit is connected to the address buffer for receiving the internal address bits.

According to an embodiment, the verify circuit can comprise at least one combinatory logic circuit providing the alarm signal when the internal address bits correspond to a higher range of addresses.

According to another embodiment, the verify circuit can comprise at least one combinatory logic circuit providing the alarm signal when the internal address bits correspond to a lower range of addresses.

The verify circuit can comprise at least two combinatory logic circuits, one providing the alarm signal when the internal address bits correspond to a lower range of addresses and the other one providing the alarm signal when the internal address bits correspond to a higher range of addresses.

The invention also relates to an integrated circuit comprising a non-volatile memory circuit according to the invention and at least one processing unit, wherein the non-volatile memory circuit is connected to the processing unit for providing the alarm signal, and wherein the processing unit is configurated for rebooting when the alarm signal is provided.

According another aspect, the invention provides a method for detecting an attack of an integrated circuit comprising a non-volatile memory having at least one memory block comprising a plurality of memory cells located at intersection of bit lines and word lines, and at least one line decoder receiving internal address bits for selecting one word line and one bit line, characterized in that the non-volatile memory provides an alarm signal when the internal address bits correspond to a forbidden address.

### Brief description of the Drawings

The invention will be detailed with reference to the annexed drawings in which:
Figure 1 shows an integrated circuit including a non-volatile memory,
Figure 2 shows a structure of a non-volatile memory circuit according to the invention,
Figure 3 details an example of verify circuit according to the invention.

### Detailed Description of the invention

In such a way to simplify the present specification, a same reference is used on different drawings for designing a same element or an equivalent element. In addition, only parts of the memory are shown on the drawings for avoiding a surcharge that may render the drawings unreadable.

In the present document, it will be made reference to active signal, inactive signal, high level, low level, level "1" and level "0". As well known by a person skilled in the art, levels "0" and "1" and a low or a high level can arbitrarily correspond to an active and inactive levels depending on the kind of transistor used or of a simple choice of the designer. So, changing a high level to a low level or a level "1" to a level "0" has no importance in relation with the invention.

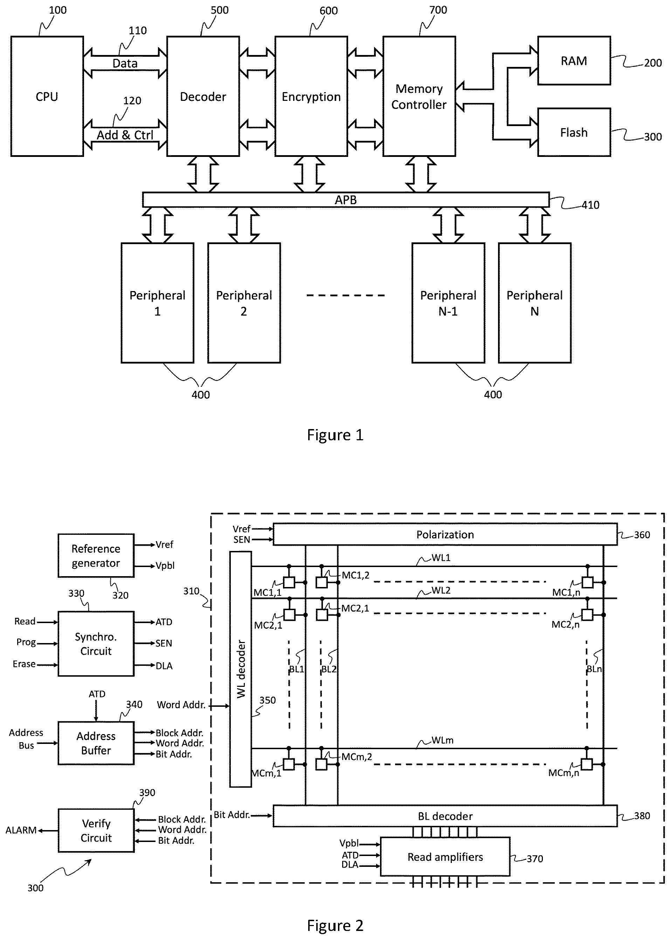

An integrated circuit of a microcontroller type, which can be also a System-on-Chip (SOC), is shown on figure 1 for showing the context in which the invention is used. The integrated circuit of figure 1 comprises a central processing unit (CPU) 100 that may include one or more microprocessor cores. The CPU 100 comprises a data bus 110, and an address and control bus 120 for communicating with memories 200 and 300 and with peripheral units 400. For securely managing the memories 200 and 300 or the peripheral units 400, the integrated circuit can comprise a decoder circuit 500, an encryption circuit 600 and a memory controller 700, both connected to the data bus 110 and the address and control bus 120 and to an application peripheral bus (APB) 410 for connecting the peripheral units 400.

Typically, control signals and address format depend on the memory type, and it is necessary to adapt them to be transparent for the CPU. The memory controller 700 can be used for addressing each memory 200 or 300 with address and control signals adapted to each type of memory that can be volatile memory 200, for example of RAM type, or non-volatile memory, for example of Flash type.

The encryption circuit 600 can be used for secure circuit, it can be of different type and can be controlled by the CPU for encrypting the data transmitted to the memories or to the peripheral units or for scrambling the addresses of the data into one memory. The encryption circuit 600 can be also transparent if no security is required for the transferred data.

The decoder circuit 500 can be used for decoding some control signals of the CPU in such a way to address the memories 200 or 300, one peripheral unit 400, or to control the encryption circuit 600 or for establishing a data transfer between one of the memories 200 or 300 and one peripheral unit 400, eventually through the encryption circuit 600.

Many other architectures are possible using different communication path between a CPU, its memories, and its peripherals units. Figure 1 showing only one example amongst many other possibilities, many functional variants of the decoder circuit 500, the encryption circuit 600, and the memory controller 700 are possible and they can be also optional. For the invention, one important thing is that a CPU 100 is connected directly or indirectly to a non-volatile memory 300 in view to read data that can be encrypted or scrambled or not. According to the invention the non-volatile memory 300 is capable to send back a check signal to the CPU 100 or to any of the intermediate components for indicating a reading operation has been performed.

The figure 2 illustrates an example of a non-volatile memory 300 according to the invention, for example a Flash memory, having a size that is small enough to be implemented into a SOC. The memory 300 can comprise one or more memory blocks 310 but only one is represented for simplifying the drawing. The memory further comprises a reference generator 320, a synchronization circuit 330 and an address buffer 340 for synchronizing the memory. For simplification reasons, only signals used for a reading operation are indicated on the drawing.

The memory block 310 comprises a plurality of word lines WL1 to WLm, a plurality of bit lines BL1 to BLn and a plurality of memory cells MC1,1 to MCm,n, each memory cell MCj,i being located and connected at the intersection of one word line WLj with one bit line BLi. The memory block 310 further comprises a word line decoder 350, a polarization circuit 360, read amplifiers 370, a bit line decoder 380 and a verify circuit 390.

The reference generator 320 provides a first reference voltage Vref and a second reference voltage Vpbl. The reference generator 320 contains a stabilized current source and the first reference voltage Vref corresponds to the intermediate voltage of a current mirror which is provided to the polarization circuit 360 for enabling the polarization circuit 360 to mirror and to provide this stabilized current to each bit line BL1 to BLn in such a way to polarize said bit lines BL1 to BLn with a constant current. The second reference voltage Vpbl corresponds to a preload voltage of the bit line used for starting each reading operation.

The synchronization circuit 330 receives the external control signals provided by the memory controller 700 which correspond to a reading signal READ, a programing signal Prog and an erasing signal Erase. Each of these signals READ, Prog and Erase triggers a sequence of signals to the different circuits constituting the memory circuit 300 for providing the requested operation. In the present specification, only the signals used for a reading operation will be detailed. The activation of the reading signal READ triggers an address validation signal ATD, a sensing signal SEN, and a data latching signal DLA with timing detailed later in this document. The address validation signal ATD is provided to the address buffer 340 and to the read amplifier 370. The sensing signal SEN is provided to the polarization circuit 360. The data latching signal DLA is provided to the read amplifiers 370.

The address buffer 340 receives the address of the data to be read from an address bus connected to the memory controller 700. The address can be multiplexed by the CPU 100, and can be demultiplexed by said memory controller, as well known by a person skilled in the art. In this document, the full address is received in parallel by the address buffer 340 from the memory controller 700. The address buffer 340 memorizes the full address at the beginning of the read operation triggered by the address validation signal ATD and till the end of the read operation for providing different address segments to several elements of the memory 300. A first segment is the block address that controls the powering of the memory block into which the reading operation is to be performed. A second segment is the word address which is sent to the word line decoder 350 for selecting one word line WLj. A third segment is the bit line address which is sent to the bit line decoder 380 for selecting one or more bit lines that correspond to the read data, depending on the number of bits that are corresponding to a data word.

The word line decoder 350 is a demultiplexer circuit that provides an active level to one word line WLj corresponding to the word address provided by the address buffer 340 while the other word lines are at an inactive level. The word line decoder 350 selects the reading of all the memory cells MCj,1 to MCj,n connected to the selected word line WLj.

The polarization circuit 360 provides a same and constant current to all the bit lines BL1 to BLn when the sensing signal SEN is active. The constant current polarizes the bit lines BL1 to BLn and participates to the charging and discharging of said bit line BL1 to BLn during the reading of the memorized value of the selected memory cells MCj,1 to MCj,n connected to the bit lines BL1 to BLn.

The read amplifiers 370 comprise amplification circuits connected to bit lines for reading the value of selected cells after a reading time. In view to read the value, the read amplifiers 370 charge the bit line to the second reference voltage Vpbl under the control of the address validation signal ATD. Then, the bit lines are charged or discharged during a reading time, and the read values are latched by the data latching signal DLA.

The bit line decoder 380 is a multiplexer connected between the read amplifiers 370 and the memory cells MCj,i for selecting the bit lines to be read. With such a selection of bit lines, the number of read amplifiers 370 can be reduced to the number of bits of a data word instead of having as many amplifiers as the number of bit lines. Such a selection can also enable to reduce the size of the polarization circuit 360.

The verify circuit 390 is connected to the address buffer 340 for receiving the address bits corresponding to the first to third address segments in such a way to verify the address used for a reading, a writing, or an erasing operation.

The memory structure of figure 2 corresponds to one type of structure amongst many other. Another memory structure can implement the invention by simply adding the verify circuit 390 for verifying the address in current use in the memory.

In the present document the verify circuit 390 is placed after the address buffer 340 which is currently used in the memory 300 but, for some memories, the address buffer can be managed externally, as an example in the memory controller 700.

Before describing the verify circuit of the invention, a short explanation is necessary on the forbidden addresses. A memory can have a certain number of address bits for addressing its memory area. As an example, the number of address bits can be equal to 17, allowing to address a maximum of 2¹⁷ words of data contained in the memory. But sometimes, the memory does not comprise an area corresponding to the maximum of addressable words, because it is not necessary to have so much memory and it is preferable to reduce the memory size for having a smaller chip. An upper range of addresses corresponding to unavailable memory can constitute forbidden addresses. In addition, some area of the memory can have a restricted use because this area is dedicated to manufacturing test and/or to configuration of the memory by the manufacturer. This restricted area can correspond to a lower range of forbidden addresses.

As an example, for a memory having 17 address bits, the memory can have two forbidden range of addresses, a first forbidden address range can be addresses below Hx00400 and a second forbidden range of addresses can be addresses above Hx123FF, wherein Hx indicates that the address is in hexadecimal.

In the present example, the first range of forbidden addresses can be detected for all addresses comprised between Hx00000 and Hx003FF, i.e. starting with the seven most significant bits A10 to A16 equal to zero. The second forbidden range corresponds to addresses comprised between Hx12400 and Hx1FFFF, this range of addresses having bits equal to 1 according to the following expression A16 AND ((A5 OR A14) OR (A13 AND (A12 OR A11 OR A10))).

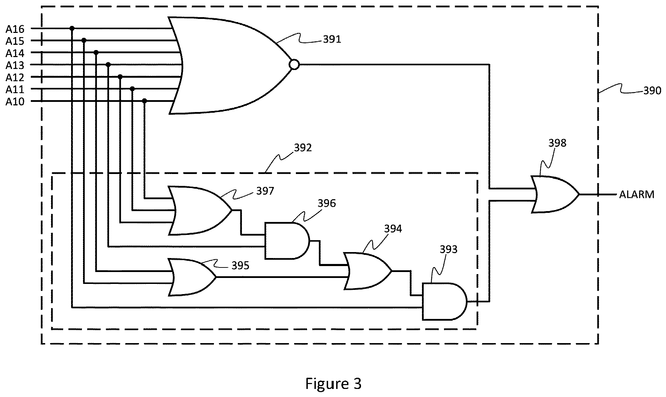

Figure 3 provides an example of verify circuit configured to manage such forbidden address ranges - below Hx00400 and above Hx123FF. As shown on figure 3, the verify circuit 390 may comprise a first combinatory logic circuit 391 and a second combinatory logic circuit 392. In this example, the first and second combinatory logic circuit 391 and 392 comprise seven inputs corresponding to the seven most significant bits A10 to A16 and one output. In the present example, the first combinatory logic circuit 391 can be made with a seven-input NOR gate 391 receiving on its inputs the seven most significant bits A10 to A16, and the second combinatory logic circuit 392 can comprise AND gates 393 and 395, and OR gates 394, 396 and 397 for translating the expression indicated above. The verify circuit 390 further comprises a two-input OR gate 398 having one input connected to the first combinatory logic circuit 391 and another input connected to the second combinatory logic circuit 392 for providing an alarm signal ALARM when the internal address bits correspond to an address inside the first forbidden range of addresses or when the internal address bits correspond to an address inside the second forbidden range of addresses.

Many variants are possible depending on the forbidden addresses. If there is only a lower range of forbidden addresses, the verify circuit 390 can comprise only the first combinatory logic circuit 391 for providing the alarm signal ALARM. If there is only a higher range of forbidden addresses, the verify circuit 390 can comprise only the second combinatory logic circuit 392 for providing the alarm signal ALARM. Also, depending on the forbidden addresses and on the memory size, the address bits connected to the verify circuit 390 can be only the address bits required for selecting the memory block and/or the word lines and/or the bit lines.

As a variant, the verify circuit 390 can be reduced by mixing the first and second combinatory logic circuit 391 and 392 together. In the present example, the seven-input NOR gate 391 can be replaced by a four-input nor gate receiving on its inputs the output of the NOR gate 397, the output of the NOR gate 395, the address bit A13 and the address bit A16.

Of course, with different forbidden address range, the verify circuit 390 should be adapted. The invention consists only in providing to the CPU 100 the alarm signal ALARM with a combinatory logic circuit. The CPU 100 can be configured for rebooting once said alarm signal ALARM is provided. For avoiding false alarm, is possible to connect the output of the verify circuit 390 to the CPU 100 through a D-latch synchronized on a global signal.

## Claims

1. A non-volatile memory circuit (300) comprising at least one memory block (310) having a plurality of memory cells (MC_{1,1} to MC_{m,n}) located at intersection of bit lines (BL1 to BLn) and word lines (WL1 to WLm), and at least one line decoder (350, 380) receiving internal address bits for selecting one word line and one bit line, **characterized in that** the non-volatile memory circuit (300) comprises at least one verify circuit (390) receiving the internal address bits and providing an alarm signal (ALARM) when the internal address bits correspond to a forbidden address.

2. The non-volatile memory circuit (300) of claim 1, wherein said memory comprises a plurality of memory blocks, and wherein one memory block is activated by at least one internal address bit.

3. The non-volatile memory circuit (300) according to claim 1 or 2, wherein said memory comprises at least one address buffer (340) for memorizing an address and for providing the internal address bits, and wherein the verify circuit (390) is connected to the address buffer (340) for receiving the internal address bits.

4. The non-volatile memory circuit (300) according to one of the claims 1 to 3, wherein the verify circuit (390) comprises at least one combinatory logic circuit (392) providing the alarm signal (ALARM) when the internal address bits correspond to a higher range of addresses.

5. The non-volatile memory circuit (300) according to one of the claims 1 to 3, wherein the verify circuit (390) comprises at least one combinatory logic circuit (392) providing the alarm signal (ALARM) when the internal address bits correspond to a lower range of addresses.

6. The non-volatile memory circuit (300) according to one of the claims 1 to 3, wherein the verify circuit (390) comprises at least two combinatory logic circuits (391, 392), one providing the alarm signal (ALARM) when the internal address bits correspond to a lower range of addresses and the other one providing the alarm signal (ALARM) when the internal address bits correspond to a higher range of addresses.

7. An integrated circuit comprising a non-volatile memory circuit (300) according to one of the claims 1 to 6 and at least one processing unit (100), wherein the non-volatile memory circuit is connected to the processing unit (100) for providing the alarm signal (ALARM), and wherein the processing unit (100) is configurated for rebooting when the alarm signal is provided.

8. A method for detecting an attack of an integrated circuit comprising a non-volatile memory (300) having at least one memory block comprising a plurality of memory cells (MC_{1,1} to MC_{m,n}) located at intersection of bit lines (BL1 to BLn) and word lines (WL1 to WLm), and at least one line decoder (350, 380) receiving internal address bits for selecting one word line and one bit line, **characterized in that** the non-volatile memory (300) provides an alarm signal (ALARM) when the internal address bits correspond to a forbidden address.
